(19) Europäisches Patentamt
European Patent Office
Office européen des brevets

(11) Numéro de publication : **0 316 312 B1**

# (12) FASCICULE DE BREVET EUROPEEN

(45) Date de publication du fascicule du brevet : **04.09.91 Bulletin 91/36**

(51) Int. Cl.5 : **G01N 24/08**

(21) Numéro de dépôt : **87904275.2**

(22) Date de dépôt : **02.07.87**

(86) Numéro de dépôt international : **PCT/FR87/00260**

(87) Numéro de publication internationale : **WO 88/00699 28.01.88 Gazette 88/03**

## (54) PROCEDE D'EXCITATION RADIOFREQUENCE DANS UNE EXPERIMENTATION DE RMN.

(30) Priorité : **11.07.86 FR 8610179**

(43) Date de publication de la demande : **24.05.89 Bulletin 89/21**

(45) Mention de la délivrance du brevet : **04.09.91 Bulletin 91/36**

(84) Etats contractants désignés : **DE FR GB IT NL**

(56) Documents cités :
**Journal of Magnetic Resonance, volume 61, 1985, Academic Press Inc., (New York, US), B. Blümich et al., "Quaternions as a practical tool for the evaluation of composite rotations", pages 356-357**
**Journal of Magnetic Resonance, volume 63, 1985, Academic Press Inc., (New York, US), C. Counsell et al., "Analytical theory of composite pulses", pages 133-135**

(56) Documents cités :
**Physical review B, volume 25, No. 11, 1 Jume 1982, (New York, US), M.M. Maricq, "Application of average Hamiltonian theory tc the NMR of solids", pages 6622-6632.**
**Journal of Magnetic Resonance, volume 67, No. 1, March 1986, Academic Press Inc., (New York, US), R. Brandes et al., "Generation of tailored radiofrequency pulses by a simple audio frequency filter method. II Analysis", pages 14-27.**

(73) Titulaire : **GENERAL ELECTRIC CGR S.A.**
**100, rue Camille-Desmoulins**
**F-92130 Issy les Moulineaux (FR)**

(72) Inventeur : **LE ROUX, Patrick**
**42, rue Chaligny**
**F-75012 Paris (FR)**

(74) Mandataire : **Schmit, Christian Norbert Marie et al**
**Cabinet Ballot-Schmit 7, rue Le Sueur**
**F-75116 Paris (FR)**

EP 0 316 312 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention a pour objet un procédé d'excitation par un signal de radiofréquence dans une expérimentation de résonance magnétique nucléaire (RMN). Elle trouve plus particulièrement son application dans le domaine médical où des machines de RMN sont utilisées à des fins de diagnostic chez l'homme. Elle peut néanmoins trouver son application dans les domaines du laboratoire ou de l'industrie dès que des phénomènes de résonance magnétique sont mis en jeu.

Le phénomène de la résonance magnétique nucléaire résulte de l'orientation prise par les moments magnétiques des spins nucléaires, ci-après denommés particules, d'un corps quand ce corps est soumis à un champ magnétique orientateur constant. Pour faire apparaître ce phénomène on excite le corps par un signal de radiofréquence. On peut mesurer le signal de désexcitation des particules quand elles retournent à leur équilibre, quand leur moment magnétique se réoriente avec le champ orientateur, à la fin du basculement de cette orientation dépendant de l'excitation. L'excitation est appliquée à la totalité du corps soumis à examen, et toutes les particules du corps émettent un signal de désexcitation à son issue. Dans le domaine médical où on cherche à représenter des images de coupes du corps examiné (d'un patient), on a coutume de cantonner la naissance du phénomène de résonance à des tranches sélectionnées dont on veut donner l'image. Dans ce but on modifie localement les conditions de résonance de manière à ce que seule la tranche séléctionnée se trouve dans des conditions de résonance correspondant à la fréquence de l'excitation radiofréquence. En dehors de la tranche, les moments magnétiques ne sont pas basculés, les particules extérieures à la tranche ne restituent aucun signal de désexcitation.

La modification des conditions locales de résonance s'obtient en augmentant, ou en diminuant, l'intensité du champ orientateur dans la tranche séléctionnée. Pour des raisons scientifiques et technologiques il n'est pas possible de modifier brutalement l'intensité d'un champ magnétique continu de part et d'autre d'une tranche de l'espace. La modification du champ prend alors la forme d'une variation régulière en fonction de l'abscisse des lieux de l'espace sur un axe perpendiculaire à la tranche à sélectionner. L'intensité du champ orientateur subit donc selon cet axe un gradient, et pratiquement les champs supplémentaires, additionnés au champ constant et homogène dans tout l'espace pour provoquer cette variation, sont communément appellés les gradients de champ. La fréquence de résonance du phénomène de résonance est proportionnelle à l'intensité du champ orientateur. Pour séléctionner une tranche il convient donc, dans l'excitation radiofréquence, que le spectre de l'excitation ne contienne des composantes que comprises dans une bande limitée par des fréquences de coupures correspondant aux fréquences de résonance des particules des bords de la tranche.

L'obtention d'un signal d'excitation à spectre étroit entraine que ce signal ne peut être instantané. Il dure un certain temps. En pratique des puissances de quelques kilowatts, appliquées pendant des durées de quelques dizaines de millisecondes, sont courantes. Le fait que l'impulsion d'excitation n'est pas instantanée et qu'au contraire elle dure un certain temps provoque alors des perturbations dans le signal de désexcitation. En effet, du fait du gradient de champ, les particules des bords de la tranche ne résonnent pas à des mêmes fréquences. Par exemple si le milieu de la tranche résonne à une fréquence $f_0$, les bords amont et aval de la tranche, par rapport à l'orientation du champ, peuvent résonner à des fréquences $f_0 - \Delta f$. ou $f_0 + \Delta f$ respectivement et il en résulte que l'historique de l'excitation dans les bords de la tranche n'est pas le même qu'au centre bien que la durée de l'excitation ait été la même pour toutes les particules de la tranche. Si le basculement géométrique de tous les moments magnétiques est correctement obtenu pour une énergie d'excitation donnée (par exemple ils se retrouvent tous dans un plan perpendiculaire au champ orientateur pour une excitation à 90°), leur orientation n'est alors pas unique. Elle peut au contraire être distribuée dans toutes les directions contenues dans un plan. L'orientation de chaque moment y depend de l'abscisse des points considérés dans la tranche. En effet dans leur mouvement de précession forcée pour rejoindre le basculement géométrique recherché, les moments magnétiques ont emprunté des trajectoires différentes. Ces trajectoires sont différentes car les vitesses de précession sont liées aux fréquences de résonance. Comme l'orientation initiale des moments magnétiques est la même pour tous, on comprend qu'il n'y a aucune raison à priori pour que cette orientation soit unique à la fin du basculement. Si on n'y prend garde les moments magnétiques des divers points de la tranche peuvent se trouver à ce point désorientés, déphasés, les uns par rapport aux autres que le signal éléctromagnetique de restitution peut avoir une moyenne nulle. Il est alors impossible d'en tirer une information physique.

En outre le phénomène de résonance magnétique ne se situe pas à une fréquence unique, mais plutôt à des fréquences voisines. L'écart entre ces fréquences et une fréquence de référence est appelé le décalage chimique (en litérature anglo-saxonne : chemical shift). Cet écart est en général inférieur à 2 $\Delta f$. Il est recherché par les praticiens une excitation qui serait capable, pour une expérimentation donnée, de différencier la réponse correspondant à chaque valeur de se décalage chimique. De cette manière il serait possible, en particulier dans les images médicales, de faire une séparation eau-graisse dans les tissus. En effet pour les différents tissus,

si le décalage de l'eau par rapport à la graisse a une même valeur en fréquence, les amplitudes des composantes n'ont pas des mêmes valeurs d'un tissus à l'autre. Par ailleurs, dans une autre type d'application et en particulier dans le domaine de l'imagerie, il est envisagé de construire des excitations dites multicoupes ou plutôt multitranches. Le but serait de profiter d'un gradient qui s'étend dans l'espace sur une longueur bien supérieure à l'épaisseur de la tranche et de disposer d'une excitation susceptible d'exciter, en même temps, plusieurs tranches, non contigües de préférence, de manière à accélerer les procédés de reconstruction d'image. Or le travail entrepris pour la définition des impulsions d'excitation classique (à 90° et à 180°) a paru à ce point complexe que l'homme du métier n'envisage pas d'en augmenter encore la complexité pour produire maintenant de telles excitations.

Dans l'état de la technique le problème de la détermination du signal d'excitation a été résolu par des approximations successives et par des tâtonnements qui peu à peu ont permis de déterminer l'historique de son amplitude pendant la durée de l'impulsion de manière à ce que des résultats désirés soient atteints. Cependant, malgré les mois de travail nécessaires pour arriver à ces résultats, l'optimisation des impulsions d'excitation n'est pas garantie, notamment en ce qui concerne la puissance totale mise en oeuvre ainsi que la puissance instantanée. Le but de la présente invention est de proposer un procédé de determination de l'excitation qui permette en plus de tenir compte d'un critère d'optimisation, même éventuellement différent de ceux-ci.

La technique utilisée dans l'état de la technique pour déterminer les excitations en RMN de protons consiste essentiellement à diviser une durée prédeterminée d'excitation en un nombre suffisant de périodes, par exemple 40, et à calculer pour chacune des abscisses de la tranche la rotation, pendant chaque période, du moment magnétique des protons qui s'y trouvent. Le calcul est entrepris en fonction d'un paramètre représentatif de l'amplitude de l'excitation pendant la période correspondante. On fait évoluer dans le temps ce paramètre pendant la durée de l'excitation. Le mouvement du moment magnétique est un mouvement de précession dû à la fréquence de résonance, donc dépendant de l'abscisse dans la tranche, combiné à un mouvement de nutation imposé par l'excitation radiofréquence, identique pour toute la tranche. Aussi il met en jeu pour déterminer la composante selon une direction de l'espace du moment magnétique d'une particule à la fin d'une période, les composantes selon les trois directions de l'espace du moment magnétique de cette particule avant le début de la période, ces trois composants dépendant, du fait du gradient, de l'abscisse du point dans la tranche. En conséquence le calcul doit être entrepris abscisse par abscisse pour toutes les abscisses dans l'épaisseur le long de la tranche.

Dans la pratique ces calculs ont été entrepris pour une centaine d'abscisses réparties régulièrement au travers, et un peu de part et d'autre, de la tranche. Le travail de détermination a consisté à faire la totalité de ce calcul, et à le reprendre un certain nombre de fois en modifiant, période par période, l'historique de l'évolution du paramètre de manière à obtenir en fin d'impulsion une définition recherchée en amplitude et en phase du basculement des moments magnétiques des particules soumises à l'expérimentation. Ces calculs concernent toutes les particules dans la tranche, et voisine de la tranche, c'est à dire un ensemble de fréquences de résonance. Dans une autre approche, justifiée uniquement pour de faibles angles de nutation, par exemple inférieurs à 30°, on utilise le fait que l'expression de l'aimantation transverse en fonction de la fréquence de résonance est directement la transformée de Fourier du signal temporel d'excitation. Cette hypothèse devient peu valide quand l'angle de nutation recherché vaut 90°. Elle est complétement fausse quand il vaut 180°.

La présente invention permet de remédier aux inconvénients cités en proposant une méthode de calcul de l'impulsion d'excitation complétement différente. Dans cette méthode on ne calcule pas en chaque abscisse directement l'angle de nutation de chaque moment magnétique. On exprime seulement, sous une forme analytique polynômiale en fonction de la fréquence de résonance, la probabilité que ce moment ait une orientation désirée à la fin de l'excitation. L'expression sous forme polynômiale permet de s'affranchir, dans les calculs, de l'information relative à la localisation des protons concernés (ou de leur fréquence de résonance ce qui revient au même) de manière à pouvoir proposer une solution présentant pour toutes les fréquences de résonance impliquées un meilleur compromis vis à vis d'un critère d'optimisation. En ramenant cette optimisation à des synthèses de filtres par transformée de Fourier, l'invention permet alors d'aboutir rapidement à une solution recherchée (en quelques minutes).

La présente invention a pour objet un procédé d'excitation radiofréquence dans une expérimentation de RMN, excitation en réponse à laquelle les basculements de moments magnétiques de particules soumises à l'expérimentation sont définis en amplitude et en phase pour un ensemble de fréquences de résonance donné caractérisé en ce que :

— on écrit l'équation de Schrödinger relative à l'amplitude de probalité de la fonction d'onde de spins résonnant à une fréquence de résonance donnée et dont l'hamiltonien dépend de la fréquence et de l'excitation radiofréquence qu'ils subissent,
— on intègre cette équation par rapport au temps,

— on en déduit les expressions analytiques polynômiales des amplitudes de probabilité à la fin de l'excitation en fonction de la fréquence de résonance, ces expressions polynômiales étant de degré égal à un nombre de périodes élémentaires dont la somme des durées est égale à la durée de l'excitation, et ces expressions étant paramètrées par des coefficients représentatifs de l'historique de l'excitation pendant ces périodes,

— on optimise ces coefficients à l'aide d'algorithmes de calcul de façon à ce que les polynômes s'approchent au mieux d'une forme désirée

— on déduit les caractérisitiques, pendant chaque période, de l'excitation qui conduit à cette réponse définie.

— et on excite les particules avec une telle excitation.

La présente invention sera mieux comprise à la lecture de la description qui suit et à l'examen des figures qui l'accompagnent. Cette description n'est pas limitative de l'invention. Notamment, l'application d'imagerie évoquée n'est qu'un cas particulier de détermination d'une excitation radiofréquence.

Les figures montrent :

— figure 1 : une représentation schématique d'une machine de RMN ;

— figures 2 et 3 : des allures d'enveloppes d'amplitude d'excitation déterminées selon l'invention.

La figure 1 représente schématiquement une machine d'imagerie par résonance magnétique nucléaire. Cette machine comporte essentiellement des moyens 1 pour produire un champ magnétique orientateur, constant et homogène, $B_0$ dans un lieu où est placé un corps 2 à examiner. Le corps 2 est soumis à cet endroit à une excitation par un signal de radiofréquence, produite par le générateur 3 alimentant une antenne 4. L'antenne sert également à prélever le signal de désexcitation et à l'acheminer, au moyen d'un duplexeur 5, sur des moyens de réception et de traitement 6. A l'issue du traitement, l'image d'une coupe 7 du corps 2 peut être visualisée sur un dispositif 8 de visualisation. Pour soumettre les moments magnétiques des protons du corps 2 situés dans la tranche 7 au phénomène de résonance, et eux seuls, on a mis en oeuvre des bobines de gradients 9 alimentées par un générateur 10 d'impulsions de gradient. Tous ces moyens fonctionnent sous le pilotage d'un séquenceur 11. En supposant que le champ magnétique suplémentaire appliqué par les bobines 9 varie linéairement selon un axe z parallèle au champ $B_0$, on peut dire que les bords de la tranche 7, bords 12 et 13 respectivement en amont et en aval, rencontrent des conditions de résonance différentes et que les fréquences de résonance des protons qui s'y trouvent sont différentes.

Dans l'invention, pour déterminer l'excitation radiofréquence, on écrit l'équation de Schrödinger relative à l'amplitude de probabilité de la fonction d'onde de spins résonnant à une fréquence de résonance donnée. Cette expression est la suivante :

$$j \frac{d|\varphi>}{dt} = H_a |\varphi>$$

Dans cette formule $H_a$ est l'hamiltonien de spin, il dépend de la fréquence et de l'excitation radiofréquence que subissent les spins résonnants. Le terme $|\varphi>$ représente la fonction d'onde. Cet hamiltonien peut s'écrire de la manière suivante :

$$H_a = \frac{1}{2} \begin{vmatrix} -w & -w_x + jw_y \\ -w_x - jw_y & w \end{vmatrix}$$

Dans ces équations j est le nombre complexe tel que $j^2 = -1$. Les pulsations w, et $w_x$ et $w_y$ sont, respectivement, l'écart de pulsation de résonance dans la tranche 7 en fonction de l'abscisse selon $\underline{z}$ des protons concernés, et les représentations des composantes radiofréquence du champ d'excitation $\overline{B_1}$ émis par l'antenne 4. Ces composantes sont évaluées dans un repère tournant à une pulsation $w_0$, correspondant à la porteuse de l'excitation et à la fréquence de résonance des protons situés au centre de la tranche 7. De l'équation de Schrödinger on tire l'expression suivante :

$$\begin{vmatrix} \frac{da}{dt} \\ \frac{db}{dt} \end{vmatrix} = \begin{vmatrix} \frac{jw}{2} & -\frac{w_1 e^{-j\Phi}}{2} \\ \frac{w_1 e^{j\Phi}}{2} & \frac{-jw}{2} \end{vmatrix} \begin{vmatrix} a \\ b \end{vmatrix} \quad (I)$$

Où a et b sont les amplitudps de probabilité pour que les spins des protons considérés soient dans un état respectivement positif ou négatif après transformation par l'opérateur moment cinétique selon z. Dans l'expression I on a posé :

$$j(w_x + jw_y) = w_1 e^{j\varnothing}$$

où $w_1$ est l'amplitude de l'excitation et où $\varnothing$ est sa phase d'émission par rapport aux axes x et y. Cette phase est conventionellement nulle quand l'émission est selon l'axe – y.

Pour intégrer l'équation I par rapport au temps on procède d'une manière préférée à une approximation, de type connu, dite par "impulsions dures" ou encore "hard pulse". Selon cette approximation on considère que les protons sont soumis, pendant l'excitation, à deux actions différentes. Une première action permanente est relative à la présence du gradient de champ orientateur dans la tranche 7. Elle a pour effet le décalage de pulsation de résonance w. La deuxième action $w_1$ correspond à l'excitation proprement dite. Dans la pratique $w_1$ évolue dans le temps et c'est son évolution que l'on recherche. En échantillonnant $w_1$ on peut la représenter sous la forme d'une suite de valeurs bloquées en paliers pendant des périodes élémentaires et évoluant brutalement, d'un palier à un autre, de la fin d'une période au début d'une autre. L'approximation évoquée consiste à remplacer l'évolution par palier de la deuxième action par une succession d'impulsions de type équivalant à une fonction de Dirac, de durée $\varepsilon$ très courte et dont l'amplitude $w_i$ est égale à $w_1(t) \cdot \tau/\varepsilon$ où $w_1(t)$ est la valeur des paliers de l'excitation radiofréquence et où $\tau$ est la durée d'une période élémentaire. L'effet de cette approximation est de simplifier notablement l'équation I. En effet on peut dire que pendant les impulsions dures, elle s'écrit :

$$\begin{vmatrix} \frac{da}{dt} \\ \frac{db}{dt} \end{vmatrix} = \begin{vmatrix} 0 & \frac{w_i}{2} e^{-j\Phi_i} \\ \frac{w_i}{2} e^{j\Phi_i} & 0 \end{vmatrix} \begin{vmatrix} a \\ b \end{vmatrix}$$

parce que $w_i$ est très supérieure à l'effet du gradient de champ orientateur.

Hors des périodes d'application des excitations, cette expression peut s'écrire simplement :

$$\begin{vmatrix} \frac{da}{dt} \\ \frac{db}{dt} \end{vmatrix} = \begin{vmatrix} j\frac{w}{2} & 0 \\ 0 & \frac{-jw}{2} \end{vmatrix} \begin{vmatrix} a \\ b \end{vmatrix}$$

puisque dans ce cas l'impulsion de Dirac n'est pas présente. On peut intégrer chacune des deux expressions précédentes par rapport au temps. Le calcul est classique, et on peut écrire respectivement :

$$\begin{vmatrix} a_i^+ \\ b_i^+ \end{vmatrix} = \begin{vmatrix} \cos \Theta_i/2 & -e^{-j\Phi_i} \cdot \sin \Theta_i/2 \\ e^{j\Phi_i} \cdot \sin \Theta_i/2 & \cos \Theta_i/2 \end{vmatrix} \begin{vmatrix} a_i^- \\ b_i^- \end{vmatrix}$$

et

$$\begin{vmatrix} a_{i+1}^- \\ b_{i+1}^- \end{vmatrix} = \begin{vmatrix} e^{j\frac{w\tau}{2}} & 0 \\ 0 & e^{-j\frac{w\tau}{2}} \end{vmatrix} \begin{vmatrix} a_i^+ \\ b_i^+ \end{vmatrix}$$

Dans ces expressions les amplitudes de probabilité sont affectées du signe – ou du signe + selon qu'elles correspondent à ces probabilités avant ou après l'application de l'impulsion de Dirac i correspondant. Elles sont affectées d'indices i ou i + 1 selon le rang i de l'impulsion de Dirac qui les précède. Dans ces expressions $\theta_i = w_i \cdot \varepsilon = w_1(t) \cdot \tau$. Si par ailleurs on pose pour simplifier les expressions :

$$e^{jwt} = z$$

$$\cos \Theta/2 = c_i$$

et $$e^{j\Phi_i} \sin \Theta_i/2 = s_i$$

on peut écrire qu'après une n ième impulsions de Dirac, en omettant les signes + :

$$\begin{vmatrix} a_n \\ b_n \end{vmatrix} = \begin{vmatrix} c_n & -\overline{s_n} \\ s_n & c_n \end{vmatrix} \begin{vmatrix} z^{1/2} & 0 \\ 0 & z^{-1/2} \end{vmatrix} \begin{vmatrix} a_{n-1} \\ b_{n-1} \end{vmatrix} \qquad \text{(II)}$$

De cette écriture on va déduire des expressions de $a_n$ et $b_n$ en fonction de $a_{n-1}$ et $b_{n-1}$. Et dans ces dernières expressions, en remplaçant $a_n$ et $b_n$ par :

$$\alpha_n = a_n / z^{n/2}$$

et

$$\beta_n = b_n / z^{n/2} \qquad \text{(III)}$$

on peut écrire :

$$\alpha_n = c_n \alpha_{n-1} - \overline{s_n}\, z^{-1} \beta_{n-1}$$

$$\beta_n = s_n \alpha_{n-1} + c_n z^{-1} \beta_{n-1} \qquad \text{(IV)}$$

Si on suppose connue l'orientation du moment magnétique avant une première impulsion de Dirac, en particulier s'il est orienté parallèlement à $B_0$, on peut dire que :

$$\begin{vmatrix} a_0^- \\ b_0^- \end{vmatrix} = \begin{vmatrix} 1 \\ 0 \end{vmatrix} = \begin{vmatrix} \alpha_0^- \\ \beta_0^- \end{vmatrix}$$

et donc

$$\begin{vmatrix} a^+_0 \\ b^+_0 \end{vmatrix} = \begin{vmatrix} a_0 \\ b_0 \end{vmatrix} = \begin{vmatrix} c_0 \\ s_0 \end{vmatrix} = \begin{vmatrix} \alpha_0 \\ \beta_0 \end{vmatrix}$$

Dans la dernière expression, $\alpha_0$ et $\beta_0$ dépendent de $c_0$ et $s_0$ qui sont représentatifs de l'amplitude de la première impulsion de Dirac numérotée 0. Cette formulation peut encore s'écrire :

$$\alpha_0 = c_0 = h_0^0 \, z^{-0}$$

et

$$\beta_0 = s_0 = g_0^0 \, z^{-0}$$

où $z^0$ vaut conventionnellement 1. Après la deuxième impulsion (numérotée n = 1) on peut écrire :

$$\alpha_1 = c_1 \, c_0 - \overline{s}_1 \, s_0 \, z^{-1} = h_0^1 \, z^{-0} + h_1^1 \, z^{-1}$$

$$\beta_1 = s_1 \, c_0 - c_1 \, s_0 \, z^{-1} = g_0^1 \, z^{-0} + g_1^1 \, z^{-1}$$

De même après une troisième impulsion (numérotée n = 2) on peut écrire :

$$\alpha_2 = c_2(c_1 c_0 - \bar{s}_1 s_0 z^{-1}) - \bar{s}_2 z^{-1}(s_1 c_0 - c_1 s_0 z^{-1})$$

soit $$\alpha_2 = h_0^2 z^{-0} + h_1^2 z^{-1} + h_2^2 z^{-2}$$

et l'on pourrait écrire de même pour $\beta_2$ :

$$\beta_2 = g_0^2 z^{-0} + g_1^2 z^{-1} + g_2^2 z^{-2}$$

Ainsi de suite et plus généralement après la n plus unième impulsion, numérotée n, $\alpha_n$ et $\beta_n$ s'écrivent :

$$\alpha_n = h_0^n z^{-0} + h_1^n z^{-1} + \dots + h_n^n z^{-n}$$
$$\beta_n = g_0^n z^{-0} + g_1^n z^{-1} + \dots + g_n^n z^{-n} \qquad \text{(V)}$$

Avec cette expression on peut faire deux remarques importantes. Premièrement $\alpha$ et $\beta$ représentent, à un changement de variable près, les amplitudes de probabilité de la fonction d'onde transformée par l'opérateur moment cinétique selon l'axe z. On peut d'ailleurs montrer, qu'au même titre que le carré du module de a additionné au carré du module de b vaut 1, que le carré du module de $\alpha_n$ additionné au carré du module de $\beta_n$ vaut 1 également. En effet la probabilité pour que le moment magnétique existe vaut toujours 1. Deuxièmement on remarque que l'expression de $\alpha_n$ et $\beta_n$ est une expression polynômiale analytique en z. Or z correspond à la pulsation de résonance en fonction du lieu (à cause du gradient) des protons concernés dans l'espace excité. Donc z est dans l'expression du moment magnétique, le terme représentatif de la fréquence de résonance. Au même titre que $c_0$ et $s_0$ étaient déterminés par l'amplitude de la première excitation on peut dire que les coefficients $h_i^n$ et $g_i^n$ sont déterminés par la succession des différentes impulsions, jusqu'à celle de numéro n. Ces coefficients sont cependant exprimés, eux, indépendamment du lieu des protons concernés c'est à dire indépendamment de la fréquence. Autrement dit, la connaissance de tous les $h_i^n$ et $g_i^n$ permet de déduire l'allure du moment magnétique à la fin de l'excitation quelle que soit la fréquence de résonance, c'est à dire quelle que soit la place des protons dans la tranche.

Dans l'invention on se préoccupe alors de rechercher de tels coefficients $h_i^n$ et $g_i^n$ en imposant des contraintes liés aux valeurs de w. En quelque sorte, on va imposer que les expressions de $\alpha_n$ et $\beta_n$soient les équations d'un filtre ayant une valeur donnée dans sa bande passante et ayant une autre valeur donnée à l'extérieur.

On peut écrire en reportant la valeur $\alpha_{n-1}$ et de $\beta_{n-1}$ en fonction des coefficients $h_i^{n-1}$ et $g_i^{n-1}$ de l'expression V dans l'expression IV de $\alpha_n$ et $\beta_n$, eux-mêmes écrits en fonction des coefficients $h_i^n$ et $g_i^n$ :

$$h_i^n = c_n \cdot h_i^{n-1} - \bar{s}_n \cdot g_{i-1}^{n-1}$$

et $$g_i^n = s_n \cdot h_i^{n-1} + c_n \cdot g_{i-1}^{n-1} \qquad \text{(VI)}$$

L'expression IV peut en outre être inversée et devenir :

$$\alpha_{n-1} = c_n \alpha_n + \bar{s}_n \beta_n$$
$$\beta_{n-1} = z(-s_n \alpha_n + c_n \beta_n) \qquad \text{(VIII)}$$

A ce stade du calcul mathématique on peut faire les considérations suivantes. Si on s'est donné $\alpha_n$ et $\beta_n$, représentatifs d'un moment magnétique à la fin de l'excitation, on peut, connaissant $c_n$ et $s_n$ représentatifs de la dernière impulsion de Dirac de l'excitation, déduire les valeurs du moment magnétique, $\alpha_{n-1}$ et $\beta_{n-1}$, juste avant l'application de cette impulsion. De proche en proche, en déterminant à chaque fois l'impulsion précédente, on peut remonter l'évolution du moment et déterminer, à l'envers, l'historique de l'excitation depuis son origine jusqu'à sa fin. La question est alors de savoir si on peut choisir $c_n$ ou $s_n$ comme on le veut ou au contraire si ces valeurs sont imposées. Que ces valeurs soient imposées revient à dire que l'impulsion numéro $\underline{n}$ est connue en amplitude. En examinant VIII et en se rappellant que $\alpha_n$ et $\beta_n$ sont des polynômes de degré $\underline{n}$ en $z^{-1}$ il vient immédiatement :

$$0 = c_n h_n^n + \bar{s}_n g_n^n$$

et

$$0 = -s_n h_0^n + c_n g_0^n$$

En effet le polynôme de degré n – 1 en $z^{-1}$ représentatif de $\alpha_{n-1}$ ne peut contenir des termes de degré n en $z^{-1}$. De même le polynôme de degré n – 1 en $z^{-1}$ représentatif de $\beta_{n-1}$ ne peut comporter des termes en $z^{-1}$. Ce couple de conditions revient à poser les questions suivantes :

$$\frac{s_n}{c_n} = \frac{e^{j\Phi_n} \cdot \sin \Theta_n/2}{\cos \Theta_n/2} = \operatorname{tg} \frac{\Theta_n}{2} \cdot e^{j\Phi_n} = \frac{h_n^n}{\bar{g}_n^n} = \frac{g_0^n}{\bar{h}_0^n} \qquad (X)$$

Ceci revient à imposer que $\Theta_n$ et $\varnothing_n$ soient les deux inconnues d'un système de 4 équations à deux inconnues. En principe on devrait se heurter ici à une impossibilité de résolution.

Mais le fait de dire que la probabilité que le moment magnétique existe vaut 1 revient à écrire que :

$$|\alpha_n|^2 + |\beta_n|^2 = 1 \qquad (VII)$$

ou encore :

$$\alpha_n \bar{\alpha}_n + \beta_n \bar{\beta}_n = 1 \qquad (VII)$$

Cette expression VII peut être developpée en remplaçant $\alpha_n$ et $\beta_n$ par leur valeur donnée dans l'expression V. En effectuant ce dernier calcul et en classant les coefficients obtenus selon les puissances de $\underline{z}$ auxquelles ils s'appliquent on peut écrire :

$$h_0^n \overline{h_n^n} + g_0^n \overline{g_n^n} \qquad = 0 \text{ termes en } z^{-n}$$

$$\overline{h_0^n}\, h_{n-1}^n + \overline{h_1^n}\, h_n^n + \overline{g_0^n}\, g_{n-1}^n + \overline{g_1^n}\, g_n^n \qquad = 0 \text{ termes en } z^{-(n-1)}$$

$$\cdots\cdots \qquad \cdots\cdots \qquad = 0$$

$$h_0^n \overline{h_0^n} + h_1^n \overline{h_1^n} + \ldots\ldots\ldots + h_n^n \overline{h_n^n} +$$

$$g_0^n \overline{g_0^n} + g_1^n \overline{g_1^n} + \ldots\ldots\ldots + g_n^n \overline{g_n^n} \qquad = 1 \text{ termes en } z^{-0}$$

$$\cdots\cdots \qquad \cdots\cdots \qquad = 0$$

$$h_0^n \overline{h_n^n} + g_0^n \overline{g_n^n} \qquad = 0 \text{ termes en } z^{n}$$

Ce système d'équations comporte n + 1 équations, et non pas 2n équations, à 2n + 2 inconnues. En effet les équations dont les termes sont en $z^{-i}$ ou en $z^{i}$ sont les mêmes. Par contre il y a bien 2n + 2 termes en $h_i^n$ et $g_i^n$ qui sont inconnus. On remarque que la première et la dernière équations réduisent l'impossibilité de détermination de $\Theta_n$ et de $\varnothing_n$ telle qu'elle apparaissait précédemment. En effet les deux derniers termes de l'expression IX sont identiques entre eux selon la condition imposée à la probabilité de l'amplitude du moment magnétique. En conséquence les deux équations à deux inconnus $\Theta_n$ et $\varnothing_n$ sont solubles. Il en résulte que $\Theta_n$ et $\varnothing_n$ sont fixés par la nature des polynômes en $h_i^n$ et en $g_i^n$ qu'on a retenus. On peut donc calculer $\alpha_{n-1}$ et $\beta_{n-1}$ en application de l'expression VIII. D'où on déduit $\theta_{n-1}$ et $\varnothing_{n-1}$. Ainsi de suite on peut calculer la séquence des impulsions qui composent l'excitation.

A ce stade de l'explication on peut résumer la situation en disant qu'on peut choisir deux polynômes de degré n parmis un ensemble important de polynômes possibles (à cause du système de n + 1 équations à 2n + 2 inconnues). On sait, une fois que de tels polynômes ont été choisis, qu'on est capable de calculer la séquence des excitations sous formes d'impulsion de Dirac qui ont conduit, à partir d'un moment magnétique d'orientation donnée, aux polynômes en question. En refaisant alors l'approximation par impulsion dure, mais à l'envers cette fois, on peut donner une valeur pseudo continue ou même continue à l'amplitude de l'excitation. Autrement dit on vient de transformer l'expression physique du phénomène. Sur cette dernière expression on peut effectuer simplement des optimisations. Toutes les optimisations porteront sur un choix, en fonction de critères d'optimisation donnés, des coefficients $h_i^n$ et $g_i^n$ dont les valeurs sont conformes aux conditions énoncées dans l'expression VII. Les calculs d'optimisation en outre reviennent à des calculs de filtres fréquentiels. On sait imposer des conditions d'amplitudes et de phases à de tels filtres.

D'un point de vue macroscopique l'effet global de l'excitation radiofréquence combinée au mouvement de précession est de soumettre l'aimantation à une rotation de paramètres angulaires $\Theta$(w), psi (w) et phi (w), où $\Theta$ psi et phi sont les angles d'Euler définissant cette rotation, w est la pulsation de résonance considérée. Chacun des trois angles $\Theta$ psi et phi est fonction, comme a et b, de l'historique de l'excitation $w_1$ (t) et peut être trouvé, pour chaque w, par intégration sur le temps des équations de Bloch. Il existe une correspondance directe entre les angles d'Euler de cette rotation et les amplitudes de probabilité, a et b, solutions de l'équation de Schrödinger (Albert Messiah, "Mecanique quantique", Tome II, pages 918, 919 et 922). Ces correspondances s'écrivent :

$$a = \varepsilon \exp(j\ \text{phi}/2) \cos(\theta/2) \exp(j\ \text{psi}/2)$$

$$b = \varepsilon \exp(-j\ \text{phi}/2) \sin(\theta) \exp(j\ \text{psi}/2)$$

$$\text{avec } \varepsilon = \pm 1$$

On peut inverser ces relations et obtenir :

$$\cos\theta = (a\bar{a} - b\bar{b}) = (\alpha\bar{\alpha} - \beta\bar{\beta})$$

soit

$$\cos\theta = 1 - 2\,\beta\bar{\beta} = 2\,\alpha\bar{\alpha} - 1$$

et

$$\text{psi} = \operatorname{Arg}(a \cdot b) = \operatorname{Arg}(z^n \cdot \alpha \cdot \beta)$$

$$\text{phi} = -\operatorname{Arg}(\bar{a} \cdot b) = -\operatorname{Arg}(\bar{\alpha} \cdot \beta)$$

On peut chercher à résoudre le problème consistant à approximer, sur tout un domaine de $\underline{w}$, un angle de nutation donné θ (w) sans s'intéresser aux angles psi et phi.

On sait que si l'excitation est un train de $\underline{n}$ impulsions de Dirac alors les $\underline{\alpha}$ et $\underline{\beta}$ résultants sont des polynômes d'ordre $\underline{n}$ en $z^{-1}$. Il est facile de voir alors, compte tenu du fait que $|z| = 1$ et donc que le conjugué de $\underline{z}$ est égal à $z^{-1}$, que $\beta\bar{\beta}$ et $\alpha\bar{\alpha}$ sont des"polynômes" de "degré" 2 n (puissance de $\underline{z}$ de – n à + n). Ces polynômes ont par ailleurs la particularité d'être symétriques et de pouvoir s'écrire :

$$\beta\bar{\beta} = \rho_0 + \sum_{1}^{n} (\rho_i z^{-i} + \bar{\rho}_i z^{i}) = \rho(z)$$

où

$$\rho_i = \sum_{\ell=0}^{n-i} \bar{g}_\ell^n \cdot g_{\ell+i}^n$$

Trouver les coefficients $\rho_i$ qui approximent au mieux une réponse en fréquence (cos θ (w) – 1)/2 donnée est un problème classique de filtrage. Voir par exemple A.V. Oppenheim, R.W. Schaefer, Digital Signal Processing, Chapitre 5. On utilisera de façon préférée l'algorithme dit d'échange de Remez exposé dans cette référence et publié dans les IEEE Transactions on Circuit Theory, CT-19, 189-194, Mars 1972 par MM T.W. Parks et J.H. McClellan sous le titre "Cheby s hev approximation for non recursive digital filters with linear phase". En plus de son caractère d'optimalité cet algorithme présente l'avantage de pouvoir rendre compte facilement de la contrainte :

$$0 < \beta\bar{\beta} < 1$$

Une fois les $\rho_i$ determinés on peut trouver les polynômes ρ(z). En effet si $z_i$ est un zéro de β alors $\rho(z) = \beta\bar{\beta}$ a comme zéro $z_i$ et $1/\bar{z}_i$. A l'inverse connaissant les 2n zéros de ρ(z) on construit $\bar{\beta}$ en choisissant parmis chacun des $\underline{n}$ couples ($z_i$, $1/\bar{z}_i$) un de ses éléments $z_i$ ou $1/\bar{z}_i$. Il y a donc $\underline{n}$ choix binaires possibles et, pour un $\beta\bar{\beta}$ donné, $2^n$ solutions possibles pour $\underline{\beta}$. Il en va de même pour $\underline{\alpha}$ : pour $\alpha\bar{\alpha}$ donné il y a $2^n$ solutions $\underline{\alpha}$ possibles. Il y a donc, pour un cos θ (w) approximé au mieux par un ρ(z), $4^n$ solutions pour les 2 autres angles d'Euler psi et phi.

On peut aussi, par recherche des zéros de ρ(z) et 1 – ρ(z), examiner toutes les solutions psi et phi, mais on conçoit que cette opération est longue et fastidieuse. En fait le nombre de solutions possibles n'est pas aussi grand qu'il y parait de prime abord car l'algorithme de Remez tend à placer le plus de zéros possibles sur le cercle unité $|z| = 1$, et dans ce cas $z_i = 1/\bar{z}_i$.

En ce qui concerne $\underline{\alpha}$ on peut généralement se restreindre à chercher une solution à phase minimum. Cette solution correspond à choisir entre les zéros $z_i$ et $1/|\bar{z}_i$ celui qui est à l'intérieur du cercle unité. En fait cette solution peut être trouvée sans avoir à chercher les zéros de 1 – ρ(z) grâce à un algorithme simple inventé par MM. R. Boite et H. leich, publié dans Signal Processing, 1981, pages 101 à 108 par North Holland Publishing Compagny dans un article dont le titre est : "A NEW PROCEDURE FOR THE DESIGN OF HIGH ORDER MINIMUM PHASE FIR DIGITAL OR CCD FILTERS". D'un point de vue physique la solution à phase minimum pour $\underline{\alpha}$ se justifie par le fait qu'elle conduit, après inversion des équations de Shrodinger par IX, à l'énergie de l'excitation la plus faible. En effet on sait que parmis toutes les solutions $\underline{\alpha}$ de $\alpha\bar{\alpha} = 1 - \rho$, la solution à phase minimum est celle qui a le coefficient d'ordre zéro $h^n{}_0$ le plus grand. Or en reprenant les relations VI on trouve que :

$$h_0^n = \cos\frac{\theta_{n-1}}{2} \cdot \cos\frac{\theta_{n-1}}{2} \cdots\cdots\cdots\cos\frac{\theta_0}{2}$$

Si l'on prend le logarithme de cette valeur, et si on considère que les contributions apportées par chacun des $w_i$ à la nutation totale du moment magnétique sont faibles, on peut écrire, après avoir effectué un développement limité de cosinus $\theta_i$ :

$$\text{Log } h_0^n = -\frac{1}{8}\sum_0^n (\theta_i)^2$$

Comme on a vu que $h_0^n$ était le plus grand on en déduit que la somme des carrés des $\theta_i$ est la plus faible. Il en résulte que les impulsions, dont la succession provoque une somme des deux angles d'Euler psi + phi minimum, sont justement celles qui correspondent à l'énergie minimale d'excitation pour un angle de nutation $\theta$ donné. Ce résultat n'était pas connu précèdemment.

Une approche plus restrictive de la définition des polynômes $\underline{\alpha}$ et $\underline{\beta}$ consiste à imposer dès le départ des contraintes sur les phases arg (a) ou arg (b). En particulier on peut imaginer que arg (b) = 0. Ceci est équivalent à imposer que les coefficients du polynôme $\underline{\beta}$ soient symétriques, c'est à dire que

$$g^n_{n-i} = g^n_i$$

Le polynôme $\underline{\beta}$ peut alors être trouvé par optimisation de l'angle de nutation $\theta$ (w) grâce à l'alogrithme de Remez. On en déduit alors $\beta\bar{\beta}$ et $\alpha\bar{\alpha}$. On choisit alors $\underline{\alpha}$ à phase minimum. La figure 2 montre l'allure d'une impulsion à 180° trouvée en respectant ces conditions. Cette figure est associée à un premier tableau, TAB 1, de valeurs de l'amplitude de l'excitation en fonction d'un certain nombre de périodes (les périodes sont données en temps réduit et les amplitudes en radian s). Parce que la forme de cette excitation est symétrique dans le temps, seules les 1 + n/2 premières périodes sont tabulées. Dans l'exemple il y en a 59. Pour des raisons technologiques cette impulsion peut conduire à des puissances crêtes, au centre, trop fortes pour les générateurs 3 utilisés. On peut alors modifier son allure en prenant une des autres solutions de $\underline{\alpha}$. On aboutit alors à une impulsion dont l'enveloppe est celle représentée sur la figure 3, et qui correspond, dans les mêmes conditions, à un deuxième tableau de valeurs : TAB 2. A l'expérience il apparait que le respect à 3 ou 5% près des valeurs indiquées dans ces tableaux n'est pas préjudiciable au résultat des expérimentations de RMN qui les utilisent.

TAB 1

| |
|---|
| -5.90491088820821E-002 |
| -8.96631980134976E-003 |
| -9.23166598598407E-003 |
| -9.19677465040708E-003 |
| -8.83432825998123E-003 |
| -8.12591456552324E-003 |
| -7.05961652094723E-003 |
| -5.63477557258307E-003 |
| -3.86253911015924E-003 |
| -1.76486475138458E-003 |
| 6.25476838024989E-004 |
| 2.26440690345683E-003 |
| 6.09583076591332E-003 |
| 9.05216904390593E-003 |
| 1.20555142561780E-002 |
| 1.50196768191874E-002 |
| 1.78517413596757E-002 |
| 2.04537546376259E-002 |
| 2.27246168285321E-002 |
| 2.45630146956734E-002 |
| 2.58710287153642E-002 |
| 2.65578861205690E-002 |
| 2.65431355656157E-002 |
| 2.57591139192740E-002 |
| 2.41545403155147E-002 |
| 2.16956917805766E-002 |
| 1.83713380832749E-002 |
| 1.41945062109303E-002 |
| 9.20457660885527E-003 |
| 3.46765560648096E-003 |
| -2.92329100733593E-003 |
| -9.84733908635224E-003 |
| -1.71530173784658E-002 |
| -2.46571535816664E-002 |
| -3.21442219464214E-002 |
| -3.93693814016602E-002 |
| -4.60621260029187E-002 |
| -5.19305174898276E-002 |
| -5.66364696748610E-002 |
| -5.98922285225749E-002 |
| -6.13121319539390E-002 |
| -6.05981140778251E-002 |
| -5.74494739112295E-002 |
| -5.15620362699079E-002 |
| -4.26629999764663E-002 |
| -3.05055681138646E-002 |
| -1.48618108573401E-002 |
| 4.48331838517662E-003 |
| 2.77314167977565E-002 |
| 5.50461462341715E-002 |
| 8.64972905264657E-002 |
| 1.21951561422393E-001 |
| 1.60897065098579E-001 |
| 2.02203063971342E-001 |
| 2.43859077421071E-001 |
| 2.82823939221931E-001 |
| 3.15186979218870E-001 |
| 3.36828780839445E-001 |
| 3.44519101220846E-001 |

TAB 2

| |
|---|
| -6.43620153219991E-002 |
| -2.22506739796626E-002 |
| -2.49869020943108E-002 |
| -2.68990157438880E-002 |
| -2.77707368058623E-002 |
| -2.73594711916511E-002 |
| -2.54479434557955E-002 |
| -2.18635472488279E-002 |
| -1.64935465610009E-002 |
| -9.29751166465141E-003 |
| -3.19132207764246E-004 |
| 1.03029077408931E-002 |
| 2.23249500506281E-002 |
| 3.53908627237378E-002 |
| 4.90274190615515E-002 |
| 6.26451148417868E-002 |
| 7.55466371967290E-002 |
| 8.69479228151243E-002 |
| 9.60155221415116E-002 |
| 1.01921802249669E-001 |
| 1.03913138439167E-001 |
| 1.01380187889778E-001 |
| 9.39155521524178E-002 |
| 8.13463565002227E-002 |
| 6.37390221677407E-002 |
| 4.13790603273035E-002 |
| 1.47486548149161E-002 |
| -1.54839234400107E-002 |
| -4.84424410168841E-002 |
| -8.29852331684852E-002 |
| -1.17625795521197E-001 |
| -1.50471465648678E-001 |
| -1.79244867442907E-001 |
| -2.01459013842493E-001 |
| -2.14769285613060E-001 |
| -2.17434784481117E-001 |
| -2.08716918900358E-001 |
| -1.89030077066345E-001 |
| -1.59738970570616E-001 |
| -1.22847407686439E-001 |
| -8.04057612979931E-002 |
| -3.43898608033687E-002 |
| 1.34844833846245E-002 |
| 6.16742852514041E-002 |
| 1.08582606007642E-001 |
| 1.52372560401071E-001 |
| 1.90896870985005E-001 |
| 2.21841112220419E-001 |
| 2.43114767835960E-001 |
| 2.53390364178345E-001 |
| 2.52576807632722E-001 |
| 2.41983570764297E-001 |
| 2.24083705311999E-001 |
| 2.01994161175123E-001 |
| 1.78905167599749E-001 |
| 1.57651976499981E-001 |
| 1.40485395387081E-001 |
| 1.29003722671106E-001 |
| 1.24164376232861E-001 |

## Revendications

1. Procédé d'excitation par un signal de radiofréquence, dans un appareil d'expérimentation à résonance magnétique nucléaire comportant des moyens électroniques de traitement de l'information, excitation en réponse à laquelle les basculements de moments magnétiques de spins nucléaires contenus dans un volume d'investigation déterminé soumis à l'expérimentation sont définis en amplitude et en phase pour un ensemble de fréquences de résonance donné, ledit procédé étant caractérisé par les étapes suivantes :

— on introduit dans lesdits moyens l'équation de Schrödinger relative à l'amplitude de probabilité de la fonction d'onde de spins de ces particules résonnant à une fréquence de résonance donnée, l'hamiltonien de ladite équation étant constitué par une fonction dépendant de la fréquence et de la forme d'une impulsion d'excitation appliquée à ces spins,

— on intègre par rapport au temps ladite équation de Schrödinger dans lesdits moyens et l'on en déduit les expressions analytiques polynômiales des amplitudes de probabilité à la fin de l'impulsion en fonction de la fréquence de résonance, ces expressions étant d'une part, de degré égal à un nombre de périodes élémentaires dont la somme des durées est égale à la durée de ladite impulsion et, d'autre part, affectées de paramètres constitués par des coefficients représentatifs du profil d'excitation effectif causé par ladite impulsion et subi, pendant lesdites périodes, par les spins aux différents points dudit volume d'investigation,

— on optimise par lesdits moyens lesdits coefficients de façon que lesdits polynômes s'approchent aux mieux d'une forme prédéterminée désirée,

— on en déduit, pour chacune desdites périodes élémentaires, les caractéristiques d'un signal d'excitation conduisant à ladite forme prédéterminée désirée,

— on excite les spins dudit volume avec ce signal d'excitation.

2. Procédé selon la revendication 1, caractérisé en ce que pour intégrer on effectue une approximation par impulsions dures.

3. Procédé selon l'une quelconque des revendications 1 ou 2, caractérisé en ce que pour optimiser on recherche les expressions polynômiales à déphasage minimal qui correspondent à une excitation la moins puissante possible.

4. Procédé selon la revendication 3, caractérisé en ce que pour exciter on excite avec une excitation dont l'allure est celle de la figure 2 représentative, du tableau suivant, les périodes étant données en temps réduit et le amplitudes en radians :

TAB 1

| |
|---|
| -5.90491088820821E-002 |
| -8.96631980134976E-003 |
| -9.23166598598407E-003 |
| -9.19677465040708E-003 |
| -8.83432825998123E-003 |
| -8.12591456552324E-003 |
| -7.05961652094723E-003 |
| -5.63477557258307E-003 |
| -3.86253911015924E-003 |
| -1.76486435138458E-003 |
| 6.25476838024989E-004 |
| 3.26440690345683E-003 |
| 6.09583076591332E-003 |
| 9.05216904390593E-003 |
| 1.20555142561780E-002 |
| 1.50196768191874E-002 |
| 1.78517413596757E-002 |
| 2.04537546376259E-002 |
| 2.27246168285321E-002 |
| 2.45630146956734E-002 |
| 2.58710287153642E-002 |
| 2.65578861205690E-002 |
| 2.65431355656157E-002 |
| 2.57591139192740E-002 |
| 2.41545403155147E-002 |
| 2.16956917805766E-002 |
| 1.83713380832749E-002 |
| 1.41945062109303E-002 |
| 9.20457660885527E-003 |
| 3.46765560648096E-003 |
| -2.92329100733593E-003 |
| -9.84733908635224E-003 |
| -1.71530173784658E-002 |
| -2.46571535816664E-002 |
| -3.21442219464214E-002 |
| -3.93693814016602E-002 |
| -4.60621260029187E-002 |
| -5.19305174898276E-002 |
| -5.66364696748610E-002 |
| -5.98922285225749E-002 |
| -6.13121319539390E-002 |
| -6.05981140778251E-002 |
| -5.74494739112295E-002 |
| -5.15620362699079E-002 |
| -4.26629999764663E-002 |
| -3.05055681138646E-002 |
| -1.48618108573401E-002 |
| 4.48331838517662E-003 |
| 2.77314167977565E-002 |
| 5.50461462341715E-002 |
| 8.64972905264657E-002 |
| 1.21951561422393E-001 |
| 1.60897065098579E-001 |
| 2.02203063971342E-001 |
| 2.43859077421071E-001 |
| 2.82823939221931E-001 |
| 3.15186979218870E-001 |
| 3.36828780839445E-001 |
| 3.44519101220846E-001 |

5. Procédé selon la revendication 3, caractérisé en ce que pour exciter on excite avec une excitation dont l'allure est celle de la figure 3 représentative du tableau suivant, les périodes étant données en temps réduit et les amplitudes en radians :

TAB 2

| |
|---|
| -6.43620153219991E-002 |
| -2.22506739796626E-002 |
| -2.49869020943108E-002 |
| -2.68990157438880E-002 |
| -2.77707368058623E-002 |
| -2.73594711916511E-002 |
| -2.54479434557955E-002 |
| -2.18635472488279E-002 |
| -1.64935465610009E-002 |
| -9.29751166465141E-003 |
| -3.19132207764246E-004 |
| 1.03029077408931E-002 |
| 2.23249500506281E-002 |
| 3.53908627237378E-002 |
| 4.90274190615515E-002 |
| 6.26451148417868E-002 |
| 7.55466371967290E-002 |
| 8.69479228151243E-002 |
| 9.60155221415116E-002 |
| 1.01921802249669E-001 |
| 1.03913138439167E-001 |
| 1.01380187889778E-001 |
| 9.39155521524178E-002 |
| 8.13463565002227E-002 |
| 6.37390221677407E-002 |
| 4.13790603273035E-002 |
| 1.47486548149161E-002 |
| -1.54839234400107E-002 |
| -4.84424410168841E-002 |
| -8.29852331684852E-002 |
| -1.17625795521197E-001 |
| -1.50471465648678E-001 |
| -1.79244867442907E-001 |
| -2.01459013842493E-001 |
| -2.14769285613060E-001 |
| -2.17434784481117E-001 |
| -2.08716918900358E-001 |
| -1.89030077066345E-001 |
| -1.59738970570616E-001 |
| -1.22847407686439E-001 |
| -8.04057612979931E-002 |
| -3.43898608033687E-002 |
| 1.34844833846245E-002 |
| 6.16742852514041E-002 |
| 1.08582606007642E-001 |
| 1.52372560401071E-001 |
| 1.90896870985005E-001 |
| 2.21841112220419E-001 |
| 2.43114767835960E-001 |
| 2.53390364178345E-001 |
| 2.52576807632722E-001 |
| 2.41983570764297E-001 |
| 2.24083705311999E-001 |
| 2.01994161175123E-001 |
| 1.78905167599749E-001 |
| 1.57651976499981E-001 |
| 1.40485395387081E-001 |
| 1.29003722671106E-001 |
| 1.24164376232861E-001 |

**Patentansprüche**

1. Verfahren zur Anregung durch ein Hochfrequenzsignal in einem NMR-Untersuchungsapparat mit elektronischen Informationsverarbeitungsmitteln, wobei die durch die Anregung hervorgerufenen Umklappungen der magnetischen Momente der Kernspins, die in einem der Untersuchung unterworfenen, vorgegebenen Untersuchungsvolumen enthalten sind, für eine gegebene Gruppe von Resonanzfrequenzen in bezug auf die Amplitude und die Phase bestimmt werden, wobei das Verfahren gekennzeichnet ist durch die folgenden Schritte :

— Eingeben der Schrödingergleichung, die auf die Wahrscheinlichkeitsamplitude der Spin-Wellenfunktion dieser bei einer gegebenen Resonanzfreqeuenz Resonanz zeigenden Teilchen bezogen ist, in die Mittel, wobei der Hamilton- Operator der Gleichung durch eine von der Frequenz und der Form eines an diese Spins angelegten Anregungsimpulses abhängige Funktion gebildet wird,

— Integration der Schrödingergleichung bezüglich der Zeit in den Mitteln und Ableitung der analytischen Polynomausdrücke der Wahrsheinlichkeitsamplituden am Ende des Impulses in Abhängigkeit von der Resonanzfrequenz, wobei diese Ausdrücke einerseits von einem Grad sind, der gleich einer Anzahl von Elementarperioden ist, deren Gesamtdauer gleich der Dauer des Impulses ist, und andererseits mit Parametern versehen sind, die durch Koeffizienten gegeben sind, die das effektive Anregungsprofil darstellen, das durch den Impuls bewirkt wird und während der Perioden mittels der Spins an verschiedenen Punkten des Untersuchungsvolumens anliegt,

— Optimierung der Koeffizienten durch die Mittel, derart, daß sich die Polynome am besten einer gewünschten, vorgegebenen Form annähern,

— Ableitung der Eigenschaften eines zur gewünschten, vorgegebenen Form führenden Anregungssignals aus den optimierten Koeffizienten für jede der Elementarperioden,

— Anregung der Spins dieses Volumens mit diesem Anregungssignal.

2. Verfahren gemäß Anspruch 1, dadurch gekennzeichnet, daß zur Integration eine Approximation mittels kurzer Impulse ausgeführt wird.

3. Verfahren gemäß einem der Ansprüche 1 oder 2, dadurch gekennzeichnet, daß zur Optimierung die Polynomausdrücke mit minimaler Phasenverschiebung gesucht werden, die einer Anregung mit der geringstmöglichen Leistung entsprechen.

4. Verfahren gemäß Anspruch 3, dadurch gekennzeichnet, daß zum Anregen mit einer Anregung angeregt wird, deren Verlauf derjenige der Fig. 2 ist, die die folgende Tabelle darstellt, wobei die Perioden mit verkürzter Zeit und die Amplituden in Radian gegeben sind :

Tabelle 1

| |
|---|
| -5.90491088820821E-002 |
| -8.96631980134976E-003 |
| -9.23166598598407E-003 |
| -9.19677465040708E-003 |
| -8.83432825998123E-003 |
| -6.12591456552324E-003 |
| -7.05961652094723E-003 |
| -5.63477557258307E-003 |
| -3.86253911015924E-003 |
| -1.76486435138458E-003 |
| 6.25476838024989E-004 |
| 3.26440690345683E-003 |
| 6.09583076591332E-003 |
| 9.05216904390593E-003 |
| 1.20555142561780E-002 |
| 1.50196768191874E-002 |
| 1.78517413596757E-002 |
| 2.04537546376259E-002 |
| 2.27246168285321E-002 |
| 2.45630146956734E-002 |
| 2.58710287153642E-002 |
| 2.65576861205690E-002 |
| 2.65431355636157E-002 |
| 2.57591139192740E-002 |
| 2.41545403155147E-002 |
| 2.16956917805766E-002 |
| 1.83713380832749E-002 |
| 1.41945062109303E-002 |
| 9.20457660885527E-003 |
| 3.46765560648096E-003 |
| -2.92329100733593E-003 |
| -9.84733908635224E-003 |
| -1.71530173784658E-002 |
| -2.46571535816664E-002 |
| -3.21442219464214E-002 |
| -3.93693814016602E-002 |
| -4.60621260029137E-002 |
| -5.19305174898276E-002 |
| -5.66364696748610E-002 |
| -5.98922285225749E-002 |
| -6.13121319539390E-002 |
| -6.05981140778251E-002 |
| -5.74494739112293E-002 |
| -5.15620362699079E-002 |
| -4.26629999764663E-002 |
| -3.05055681138646E-002 |
| -1.48618108573401E-002 |
| 4.48331838517662E-003 |
| 2.77314167977565E-002 |
| 5.50461462341715E-002 |
| 8.64972905264657E-002 |
| 1.21951561422393E-001 |
| 1.60897063098579E-001 |
| 2.02203063971342E-001 |
| 2.43859077421071E-001 |
| 2.82823939221931E-001 |
| 3.15186979218870E-001 |
| 3.36828780839445E-001 |
| 3.44519101220846E-001 |

5. Verfahren gemäß Anspruch 3, dadurch gekennzeichnet, daß zum Anregen mit einer Anregung angeregt wird, deren Verlauf der jenige von Fig. 3 ist, die die folgende Tabelle darstellt, wobei die Perioden mit verkürzter Zeit und die Amplituden in Radian gegeben sind :

Tabelle 2

| |
|---|
| -6.43620153219991E-002 |
| -2.22906739796626E-002 |
| -2.49869020943108E-002 |
| -2.68990157438880E-002 |
| -2.77707368058623E-002 |
| -2.73594711916511E-002 |
| -2.54479434557955E-002 |
| -2.18635472488279E-002 |
| -1.64935465610009E-002 |
| -9.29751166465141E-003 |
| -3.19132207764246E-004 |
| 1.03029077408931E-002 |
| 2.23249500506281E-002 |
| 3.53908627237378E-002 |
| 4.90274190615515E-002 |
| 6.26451148417868E-002 |
| 7.55466371967290E-002 |
| 8.69479228151243E-002 |
| 9.60155221415116E-002 |
| 1.01921802249669E-001 |
| 1.03913138439167E-001 |
| 1.01380187889778E-001 |
| 9.39155521524178E-002 |
| 8.13463565002227E-002 |
| 6.37390221677407E-002 |
| 4.13790603273035E-002 |
| 1.47486548149161E-002 |
| -1.54839234400107E-002 |
| -4.84424410168841E-002 |
| -6.29852331684852E-002 |
| -1.17625795521197E-001 |
| -1.50471465648678E-001 |
| -1.79244867442907E-001 |
| -2.01459013842493E-001 |
| -2.14769285613060E-001 |
| -2.17434784481117E-001 |
| -2.08716918900358E-001 |
| -1.89030077066345E-001 |
| -1.59738970570616E-001 |
| -1.22847407686439E-001 |
| -8.04057612979931E-002 |
| -3.43898608033687E-002 |
| 1.34844833846245E-002 |
| 6.16742852514041E-002 |
| 1.08582606007642E-001 |
| 1.52372560401071E-001 |
| 1.90896870985005E-001 |
| 2.21841112220419E-001 |
| 2.43114767835960E-001 |
| 2.53390364178345E-001 |
| 2.52576807632722E-001 |
| 2.41983570764297E-001 |
| 2.24083705311999E-001 |
| 2.01994161175123E-001 |
| 1.78905167599749E-001 |
| 1.57651976499981E-001 |
| 1.40485395387081E-001 |
| 1.29003722671106E-001 |
| 1.24164376232861E-001 |

**Claims**

1. A method for the excitation by a radio frequency signal, in an NMR investigation apparatus, comprising electronic means for the treatment of the information in response to which the oscillations of the magnetic moments of nuclear spin contained in a predetermined volume to be examined submitted for the investigation are defined in amplitude and in phase for a set of given resonant frequencies, the said method being characterized by the following stages :

— the said means are supplied with the Schroedinger equation relating to the probability amplitude of the spin wave function of these particles resonating at a given resonant frequency, the Hamiltonian of the said equation being constituted by a function dependent on the frequency and on the form of an excitation pulse applied to these spins,

— the said Schroedinger equation is integrated with respect to time in the said means and the polynomial analytical expressions of the probability amplitudes are deduced at the end of the pulse as a function of the resonant frequency, said expressions being on the one hand of a degree equal to a number of elementary periods whose sum of the durations is equal to the duration of the said pulse and on the other hand being modified by parameters constituted by coefficients representative of the effective excitation profile caused by the said pulse and submitted, during the same periods, by the spins at the different points in the said investigated volume,

— using the said means to optimize the said coefficient in such a manner that the said polynomials make the best possible approach to a predetermined desired form,

— deduction for each of the said elementary periods of the characteristics of an excitation signal leading to the said predetermined desired form, and

— excitation of the spins of the said volume with this excitation signal.

2. The method as claimed in claim 1, characterised in that in order to integrate an approximation using hard pulses is performed.

3. The method as claimed in claim 1 or in claim 2, characterised in that for optimization the polynomial expressions are investigated using minimum phase shaft, such expressions corresponding to a minimum power excitation.

4. The method as claimed in claim 1 or claim 2, characterised in that excitation is performed using an excitation whose rate is similar to that of the representative figure 2 of the following table, the periods being given in a reduced time and the amplitudes being given in radians :

Table 1.

| |
|---|
| -5.90491088820821E-002 |
| -8.96631980134976E-003 |
| -9.23166598598407E-003 |
| -9.19677465040708E-003 |
| -8.83432825998123E-003 |
| -8.12591456552324E-003 |
| -7.05961652094723E-003 |
| -5.63477557258307E-003 |
| -3.86253911015924E-003 |
| -1.76486435138458E-003 |
| 6.25476838024989E-004 |
| 3.26440690345683E-003 |
| 6.09583076591332E-003 |
| 9.05216904390593E-003 |
| 1.20555142561780E-002 |
| 1.50196768191874E-002 |
| 1.78517413596757E-002 |
| 2.04537546376259E-002 |
| 2.27246168285321E-002 |
| 2.45630146956734E-002 |
| 2.58710287153642E-002 |
| 2.65578661205690E-002 |
| 2.65431355656157E-002 |
| 2.57591139192740E-002 |
| 2.41545403155147E-002 |
| 2.16956917805766E-002 |
| 1.83713380832749E-002 |
| 1.41945062109303E-002 |
| 9.20457660885527E-003 |
| 3.46765560648096E-003 |
| -2.92329100733593E-003 |
| -9.84733908635224E-003 |
| -1.71530173784658E-002 |
| -2.46571553816664E-002 |
| -3.21442219464214E-002 |
| -3.93693814016692E-002 |
| -4.60621260029187E-002 |
| -5.19305174898276E-002 |
| -5.66364696748610E-002 |
| -5.98922285225749E-002 |
| -6.13121319539390E-002 |
| -6.05981140778251E-002 |
| -5.74494739112295E-002 |
| -5.15620362699079E-002 |
| -4.26629999764663E-002 |
| -3.05053681138646E-002 |
| -1.48618108573401E-002 |
| 4.48331838517662E-003 |
| 2.77314167977565E-002 |
| 5.50461462341715E-002 |
| 8.64972905264657E-002 |
| 1.21951561422393E-001 |
| 1.60897065098379E-001 |
| 2.02203063971342E-001 |
| 2.43859077421071E-001 |
| 2.82823939221931E-001 |
| 3.15186979218870E-001 |
| 3.36828780839445E-001 |
| 3.44519101220846E-001 |

5. The method as claimed in claim 3, characterized in that for excitation an excitation is performed using an excitation whose rate is similar to that of the representative figure 3 of the following able, the periods being given in a reduced time and the amplitudes being given in radians :

Table 2

| |
|---|
| -6.43620153219991E-002 |
| -2.22506729796626E-002 |
| -2.49869020943108E-002 |
| -2.68990157438880E-002 |
| -2.77707368058623E-002 |
| -2.73594711916511E-002 |
| -2.54479434557955E-002 |
| -2.18635472488279E-002 |
| -1.64935465610009E-002 |
| -9.29751166465141E-003 |
| -3.19132207764246E-004 |
| 1.03029077408931E-002 |
| 2.23249500506281E-002 |
| 3.53908627237378E-002 |
| 4.90274190615515E-002 |
| 6.26451148417868E-002 |
| 7.55466371967290E-002 |
| 8.69479228151243E-002 |
| 9.60155221415116E-002 |
| 1.01921802249669E-001 |
| 1.03913138439167E-001 |
| 1.01380187889778E-001 |
| 9.39155521524178E-002 |
| 8.13463565002227E-002 |
| 6.37390221677407E-002 |
| 4.13790603273035E-002 |
| 1.47486548149161E-002 |
| -1.54839234400107E-002 |
| -4.84424410168841E-002 |
| -8.29852331684852E-002 |
| -1.17625795521197E-001 |
| -1.50471465648678E-001 |
| -1.79244867442907E-001 |
| -2.01459013842493E-001 |
| -2.14769285613060E-001 |
| -2.17434784481117E-001 |
| -2.08716918900358E-001 |
| -1.89030077066345E-001 |
| -1.59738970570616E-001 |
| -1.22847407686439E-001 |
| -8.04057612979931E-002 |
| -3.43898608033687E-002 |
| 1.34844833846245E-002 |
| 6.16742852514041E-002 |
| 1.08582606007642E-001 |
| 1.52372560401071E-001 |
| 1.90896870985005E-001 |
| 2.21841112220419E-001 |
| 2.43114767835960E-001 |
| 2.53390364178345E-001 |
| 2.52576807632722E-001 |
| 2.41983570764297E-001 |
| 2.24083705311999E-001 |
| 2.01994161175123E-001 |
| 1.78905167599749E-001 |
| 1.57651976499981E-001 |
| 1.40485395387081E-001 |
| 1.29003722671106E-001 |
| 1.24164376232861E-001 |

FIG_1

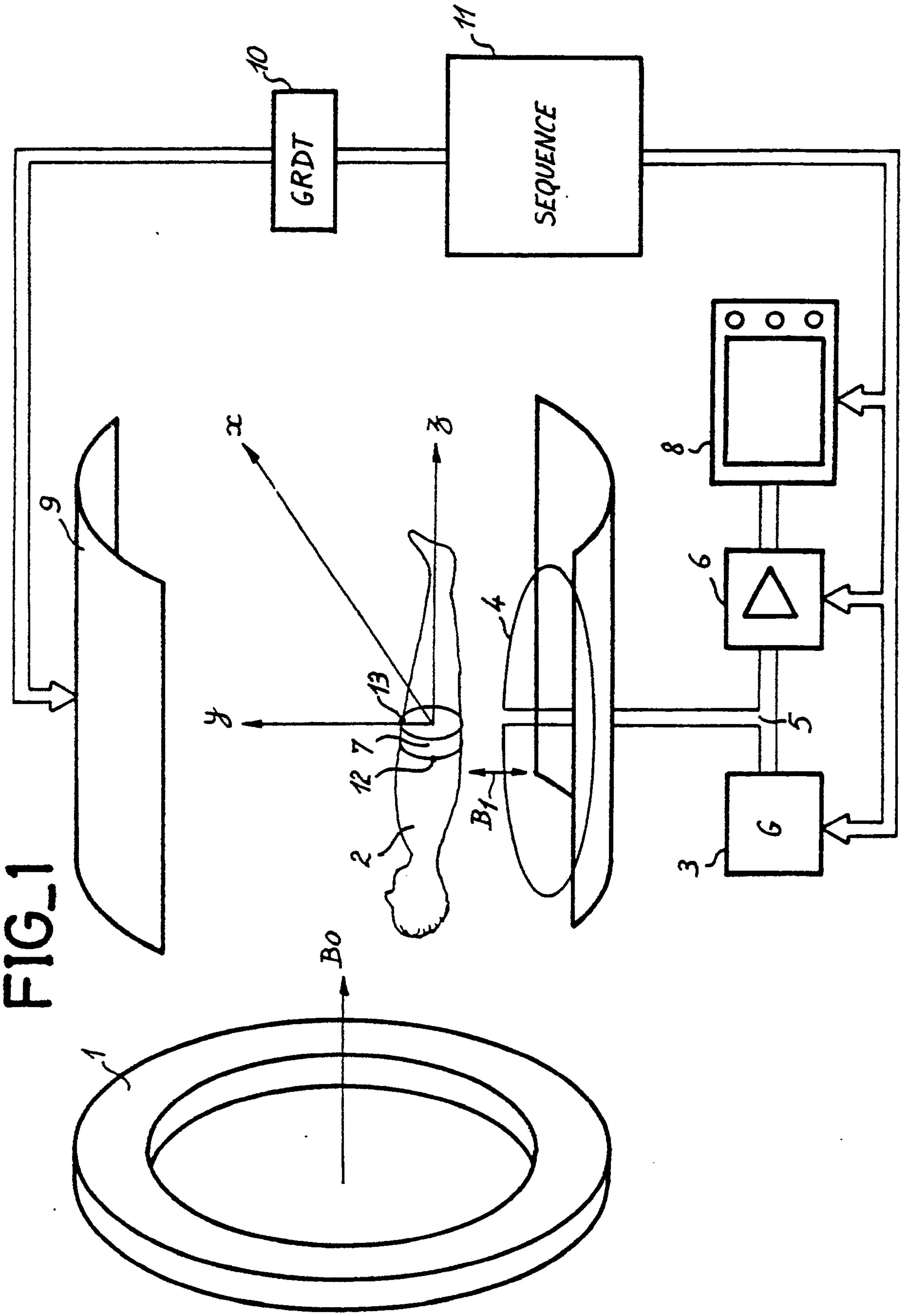

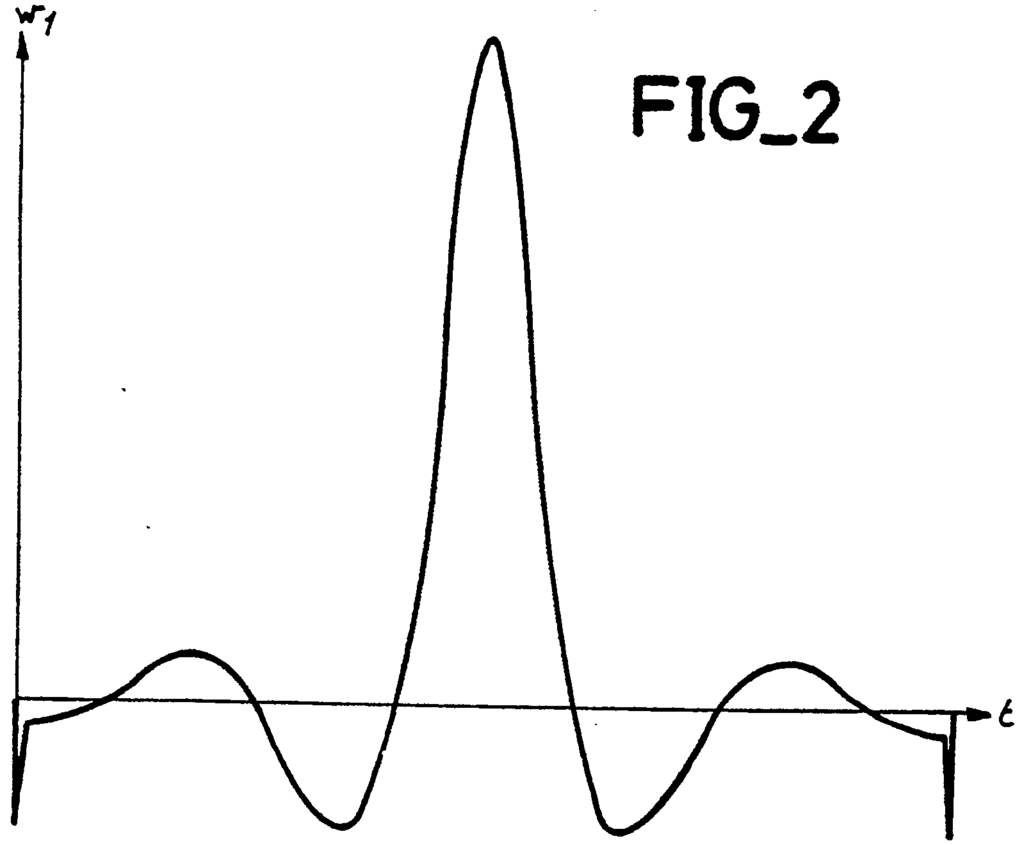


FIG_2

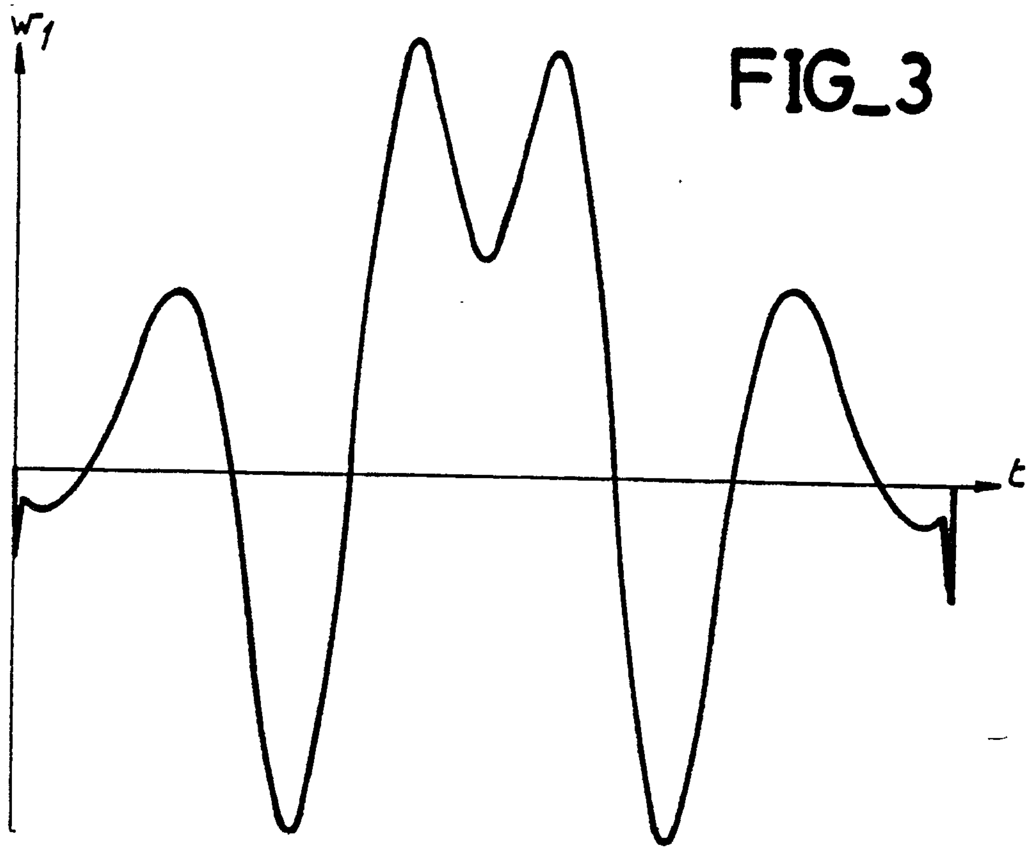


FIG_3